Europäisches Patentamt

European Patent Office

Office européen des brevets

(11) Publication number: **0 493 621 A1**

## EUROPEAN PATENT APPLICATION
### published in accordance with Art. 158(3) EPC

(21) Application number: 91913104.5

(22) Date of filing: 24.07.91

(86) International application number: **PCT/JP91/00991**

(87) International publication number: **WO 92/02049 (06.02.92 92/04)**

(51) Int. Cl.5: **H01L 27/115**

(30) Priority: **24.07.90 JP 195856/90**

(43) Date of publication of application: **08.07.92 Bulletin 92/28**

(84) Designated Contracting States: **DE FR GB IT NL**

(71) Applicant: **SEIKO EPSON CORPORATION 4-1, Nishishinjuku 2-chome Shinjuku-ku Tokyo 163(JP)**

(72) Inventor: **FUJISAWA, Akira 3-5, Owa 3-chome Suwa-shi, Nagano-ken 392(JP)**

(74) Representative: **Ouinterno, Giuseppe et al c/o Jacobacci-Casetta & Perani S.p.A. Via Alfieri, 17 I-10121 Torino(IT)**

(54) **SEMICONDUCTOR DEVICE.**

(57) A part of a Ti lower electrode (107) formed on a diffusion layer (102) of a high concentration is changed into a silicified Ti part (109), and a capacitor in which a ferroelectric layer (108) is sandwiched between the lower electrode (107) and an upper electrode is formed. By such a configuration, on a diffusion layer (102) of a high concentration, a ferroelectric capacitor can be inter-connected through a conductor of a low resistance, and a large scale integrated circuit can be realized.

FIG. 1

Technical Field

The invention relates to a semiconductor memory cell, more particularly a non-volatile semiconductor device having an electrically polarizable ferroelectric layer as a bacic material.

Background Art

A memory device based on an electrically polarizable layer has been developed since the beginning of the 50's.

Information could be stored by giving a voltage to electrodes corresponding to the upper and lower sides (corresponding to row and column numbers in case of a usual semiconductor device), thereby polarizing a region at an intersecting point of these electrodes. Moreover, a read-out process can be carried out by piezoelectrically or pyroelectrically activating a specified memory region or destructively reading out. It is further possible to permanently keep information by residual polarization of a ferroelectric without supplying any outside power from supply source. However, it was found that a circumferential device, that is, an electron control device accessary for writing and reading information, is comparatively complicated and requires large access time. Therefore, there was proposed direct integration of a ferroelectric memory element and a control module at the end of the 70's. (R.C. Cook, U.S.Patent 4,149,302 (1979))

Recently, IEDM '87, pp. 850-851, proposes a memory device laminated on an MIS-type semiconductor device as shown in Fig. 2. In Fig. 2, 201 is a P-type silicon substrate, 202 a LOCOS oxide film for separating element, and 203 and 204 are N-type diffusion layers as source and drain, respectively. 205 is a gate elctrode, and 206 is an interlayer insulating film. 208 is a ferroelectric film which constiues a capacitor sandwiched by a lower electrode 207 and an upper eletrode 209.

Such structure laminated on the upper portion of an MOS-type semiconductor device requires wiring for connecting electrodes of a ferroeletric and high concentration diffusion layers as source and drain on a semiconductor substrate, so that there is a problem of increasing an element area.

An object of the present invention is to solve such problem, and to provide a semiconductor device having a capacitor element of extremely high quality ferroelectric properties and high integration with low cost by considering a square hysteresis curve and the like.

Disclosure of Invention

The semiconductor device formed with a capacitor element having a ferroelectric layer as a basic material in the invention is characterized by connecting either one of electrodes formed by sandwiching the ferroelectric layer to a high concentration diffusion layer formed on said semiconductor substrate via a silicified titanium film.

Brief Description of the Drawings

Fig. 1 is a main cross section of the semiconductor device having an electrically polarizable ferroelectric layer as a basic material according to the invention.
Fig. 2 is a main cross section of the prior art semiconductor device having an electrically plarizable ferroelectric layer as a basic material.
Fig. 3 shows an embodiment of a memory cell circuit of the ferroelectric memory acoording to the invention.

Best Mode for carrying out the Invention

The invention will be fully explained by referring to the accompanying drawings and embodiments as follows.

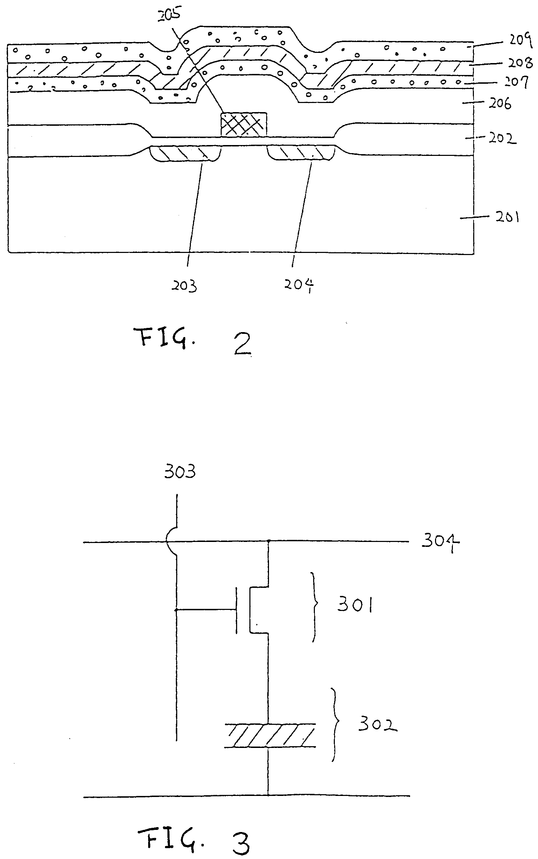

Fig. 3 shows one embodiment of a memory cell circuit of the semiconductor memory device having an electrically polarizable ferroelectric layer as a basic material. 301 is an MOS transistor, and 302 is a capacitor element applied to the ferroelectric layer according to the invention. 303 and 304 are word line and bit line,respectively. Here, an actual structure and a manufacturing method of this memory cell are explained.

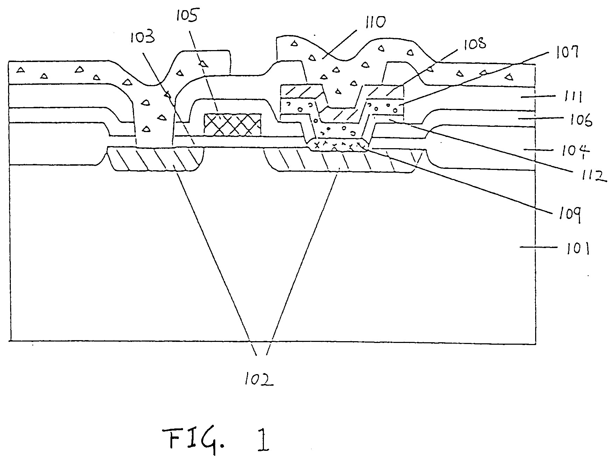

Fig. 1 shows a main cross section of the memory cell circuit shows in Fig. 3. 101 is a P-type Si surface for instance. 102 is an N-type high concentration impurity diffusion layer formed by ion implantation for instance, and to be source and drain of an MOS transistor. 103 is a gate oxide film of the MOS transistor, for instance, formed by thermal oxidation of a silicon substrate. 104 is LOCOS oxide film for separating an element. 105 is a gate electrode formed by an N-type polysilicon for instance. 106 and 111 are interlayer insulating films for instance. 106 and 111 are interlayer insulating films for forming $SiO_2$ with the use of a chemical vapor phase growing method for instance. 108 is a ferroelectric layer according to the invention. A material of this ferroelectric layer is $PbTiO_3$, PZT or PLZT according to the invention, and the ferroelectric layer is formed on one electrode shown by 107 (hereinafter referred to as a layer electrode) sandwiching a capacitor element by a sputtering method with the use of a target, in which a suitable amount of a lead component is excessively compensated with respect to a stoichiometric composition. As a material of the lower electrode 107, platinum is used for instance, and the layer electrode is formed by sputtering. 109 is a silicified titanium thin film according to the object of the invention, and silicified titanium can be obtained by forming a titanium 112 to 500Å by a sputtering method for instance, thereafter heat treating in a nitrogen atmosphere for instance at 600°C for about 15 minutes, and reacting titanium with silicon of the high concentration diffusion layer.

110 is the other electrode (hereinafter referred to as an upper elctrode) of the layer electrode of the capacitor element and is formed by sputtering aluminum for instance. In the present embodiment, the aluminum layer has role of the upper electrode and simultaniously a role of the bit line, but it is naturally preferably to separate it into two and to form the upper electrode and the bit line with different materials and layers.

With the structure shown in Fig. 1, the lower electrode of the capacitor element is directly formed on the high concentration diffusion layer via the silicified titanium thin film, so that a wiring area becomes small, and as a result, an element area becomes small and high integration becomes possible.

In order to improve dielectric characteristics of a ferroelectric film, it is necessary to heat treat the ferroelectric thin film after formation in an atmosphere containing oxygen.

In Fig. 1, when there is no silicified titanium thin film 109, after formation the ferroelectric thin film is heat treated in an atmosphere containing oxygen, and an oxide film is formed on the surface of the high concentration diffusion layer 102, so as to increase contact resistance of the layer electrode 107 and the high concentration diffusion layer 102. On the other hand, when a silicified titanium thin film 109 is formed between the lower electrode 107 and the high concentration diffusion layer 102, even if a heat treatment is conducted in an atmosphere containing oxygen, contact resistance is not increased. Moreover, it is a known fact that sheet resistance of the high concentration diffusion layer is lowered about 1/10 by forming a silicified titanium film on the surface and contributes to improvement of element performance.

Industrial Applicability

According to the invention stated above, it becomes possible to apply a heat treatment to a ferroelectric layer at about 600°C for giving extremely excellent ferroelectric characteristics by taking a switching rate, a square hystereis curve and the like into consideration, and it also becomes possible to manufacture a non-volatile semiconductor device having high integration.

Claims

1. A semiconductor device forming a capacitor element having a ferroelectric layer as a basic meterial, characterized in that either one of electrodes formed for sandwiching said ferroelectric layer is connected to a high concentration diffusion layer formed on said semiconductor substrate via a silicified titanium film.

FIG. 1

FIG. 2

FIG. 3

5

# INTERNATIONAL SEARCH REPORT

International Application No PCT/JP91/00991

## I. CLASSIFICATION OF SUBJECT MATTER (If several classification symbols apply, Indicate all) 6

According to International Patent Classification (IPC) or to both National Classification and IPC

Int. Cl$^5$  H01L27/115

## II. FIELDS SEARCHED

### Minimum Documentation Searched 7

| Classification System | Classification Symbols |
|---|---|
| IPC | H01L27/115, 29/792, 29/46 |

### Documentation Searched other than Minimum Documentation to the Extent that such Documents are Included in the Fields Searched 8

| | |
|---|---|
| Jitsuyo Shinan Koho | 1970 – 1990 |
| Kokai Jitsuyo Shinan Koho | 1972 – 1990 |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| Y | JP, A, 2-183570 (Seiko Epson Corp.), July 18, 1990 (18. 07. 90), Line 7, upper right column to lower right column, page 2 | 1 |
| X | JP, A, 1-251760 (Seiko Epson Corp.), October 6, 1989 (06. 10. 89), Line 13, upper right column to line 12, lower left column, page 2 | 1 |
| Y | JP, A, 2-82639 (Mitsubishi Electric Corp.), March 23, 1990 (23. 03. 90), Line 14, upper right column to line 2, lower right column, page 3 | 1 |
| P | JP, A, 2-288367 (Seiko Epson Corp.), November 28, 1990 (28. 11. 90) | 1 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| October 21, 1991 (21. 10. 91) | October 28, 1991 (28. 10. 91) |

| International Searching Authority | Signature of Authorized Officer |
|---|---|
| Japanese Patent Office | |

Form PCT/ISA/210 (second sheet) (January 1985)